**Europäisches Patentamt**

**European Patent Office**

**Office européen des brevets**

(19)

(11) Veröffentlichungsnummer: **0 075 890**
**B1**

(12)

# EUROPÄISCHE PATENTSCHRIFT

(45) Veröffentlichungstag der Patentschrift:
**09.12.87**

(51) Int. Cl.⁴: **H 05 K 3/30**, H 05 K 1/00

(21) Anmeldenummer: **82108851.5**

(22) Anmeldetag: **24.09.82**

(54) **Einrichtung zum Verhindern von Beschädigungen von Bausteinen bzw. Leiterbahnen auf einer Leiterplatte.**

(30) Priorität: **30.09.81 DE 3138987**

(43) Veröffentlichungstag der Anmeldung:
**06.04.83 Patentblatt 83/14**

(45) Bekanntmachung des Hinweises auf die Patenterteilung:
**09.12.87 Patentblatt 87/50**

(84) Benannte Vertragsstaaten:
**AT GB IT NL**

(56) Entgegenhaltungen:
**GB - A - 2 020 921**
**US - A - 3 390 308**
**US - A - 3 737 339**
**US - A - 4 075 420**

(73) Patentinhaber: **Siemens Aktiengesellschaft Berlin und München, Wittelsbacherplatz 2, D-8000 München 2 (DE)**

(72) Erfinder: **Hermann, Adam, Massmannstrasse 2, D-8000 München 2 (DE)**

## Beschreibung

Die vorliegende Erfindung bezieht sich auf eine Leiterplatte mit einer Einrichtung zum Verhindern von Beschädigungen von elektrischen/elektronischen Bausteinen und von Leiterbahnen infolge mechanischer Spannungen zwischen den elektrischen/elektronischen Bausteinen und den Leiterbahnen bei Verformung der Leiterplatte, wobei die Einrichtung Dehnungsglieder in den zum Anlöten der Bausteine dienenden Leiterbahnanschlüssen aufweist.

Die Gefahr der Beschädigung entweder der elektrischen/elektronischen Bausteine oder der Leiterbahnen auf der Leiterplatte tritt z. B. dann auf, wenn starre Bausteine wie z. B. Chipcarrier oder Chipkondensatoren direkt auf die Leiterbahnen der Leiterplatte gelötet werden. Gefährliche mechanische Spannungen zwischen den Bausteinen und den Leiterbahnen der Leiterplatte treten z. B. auf bei Temperaturänderungen oder bei mechanischer Belastung der Leiterplatten.

Bisher wurden die oben genannten mechanischen Spannungen durch Verwendung von Sockeln bzw. Fassungen ausgeglichen, in die die Bausteine eingesetzt wurden, oder durch an den Bausteinen selbst befindliche Beinchen auf ein ungefährliches Mass verringert. Massnahmen dieser Art stellen aber einen zusätzlichen, nicht unerheblichen Aufwand dar. Eine Lösung des Problems ist auch dadurch möglich, dass Mittel zum Dehnungsausgleich in die Leiterplatte selbst integriert sind. Derartige Mittel können z. B. Dehnungsglieder oder Dehnungsschleifen in den zum Anlöten der Bausteine dienenden Leiterbahnanschlüssen sein. Die bisher bekannten Massnahmen dieser Art waren jedoch wenig befriedigend.

Aus der US-PS 3 390 308 ist es bereits bekannt, gehäuselose integrierte Bausteine auf mit Öffnungen versehene Träger dadurch aufzubringen, dass die Verbindungsleitungen zwischen integriertem Baustein und Träger aus Leitungen bestehen, die auf Grund des sehr geringen Querschnitts flexibel sind, wodurch die durch die Löttemperatur auftretenden Spannungen zwischen Träger und Bausteinanschluss ausgeglichen werden können.

Der Erfindung liegt daher die Aufgabe zugrunde, eine Einrichtung der eingangs genannten Art zu schaffen, die bei leichter Realisierbarkeit der in die Leiterplatte selbst integrierten Mittel zum Dehnungsausgleich bessere Ergebnisse liefert.

Gemäss einer ersten Variante der Erfindung wird dies erreicht durch eine zumindest im Bereich von Einbauplätzen für die Bausteine auf dem Träger der Leiterplatte befindliche elastische Schicht mit darauf befindlichen Leiterbahnen, die aus einer Kupferschicht in an sich bekannter Weise freigeätzt sind.

Eine zweite Variante der Erfindung ist im Anspruch 5 definiert.

Weitere Einzelheiten ergeben sich aus den Unteransprüchen sowie aus den in den Fig. 1 bis 4 gezeigten Ausführungsbeispielen. Dabei zeigt:

Fig. 1 die Anordnung von Dehnungsgliedern oder Dehnungsschleifen in den zum Anlöten der Bausteine dienenden Leiterbahnanschlüssen,

Fig. 2 und 3 die erfindungsgemässe Anordnung elastischen Materials zwischen dem Träger der Leiterplatte und den Leiterbahnen und

Fig. 4 die Verwendung eines Haftverhinderers, um im Bereich der Einbauplätze die feste Verbindung der Leiterbahnen mit dem Trägermaterial zu verhindern.

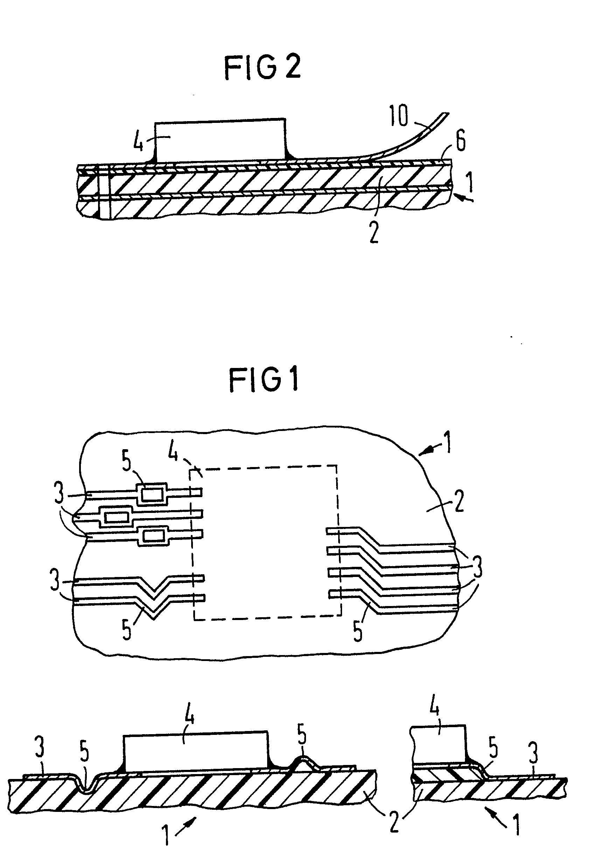

Fig. 1 zeigt schematisch eine Leiterplatte 1 aus einem Trägermaterial 2, auf dem sich verschiedene Leiterbahnen 3 befinden. Ferner ist durch die strichlinierte Linie angedeutet, dass zwischen den Enden der Leiterbahnen 3 ein z. B. elektronischer Baustein 4 mit einer Vielzahl von Anschlüssen angeordnet ist. Um mechanische Spannungen zwischen dem Baustein 4 und den Anschlüssen der Leiterbahnen 3, wie sie z. B. durch starke Temperaturänderungen oder durch mechanische Verformung der Leiterplatte auftreten können, auf ein für den Baustein 4 einerseits und die Leiterbahnen 3 andererseits ungefährliches Mass zu verringern, sind Mittel zum Dehnungsausgleich integriert. Diese können z. B. in Form von Dehnungsgliedern oder Dehnungsschleifen 5 in den zum Anlöten der Bausteine dienenden Leiterbahnanschlüssen ausgebildet sein. Figur 1 zeigt in ihren verschiedenen Teilfiguren verschiedene Ausführungsmöglichkeiten für solche Dehnungsglieder oder Dehnungsschleifen.

Damit sich mechanische Spannungen auf ein für den Baustein 4 einerseits und die Leiterbahnen 3 andererseits ungefährliches Mass verringern, ist es erforderlich, dass sich die Dehnungsglieder oder Dehnungsschleifen 5 in den Leiterbahnanschlüssen 3 gegenüber dem Trägermaterial 2 der Leiterplatte 1 geringfügig verschieben können. Wie Figur 2 zeigt, ist dies z. B. dadurch erreichbar, dass die gesamte äusserste Kupferlage 10 der Leiterplatte 1 mit Hilfe eines elastischen Klebermaterials 6 auf den Träger 2 aufgebracht ist und aus dieser dann die Leiterbahnen in an sich bekannter Weise frei geätzt sind. Durch das elastische Klebermaterial 6 zwischen den Leiterbahnen 3 und dem Trägermaterial 2 können sich die Leiterbahnanschlüsse beim Auftreten von mechanischen Spannungen zwischen diesen und dem Baustein 4 soweit verschieben, dass die mechanischen Spannungen auf ein ungefährliches Mass verringert werden.

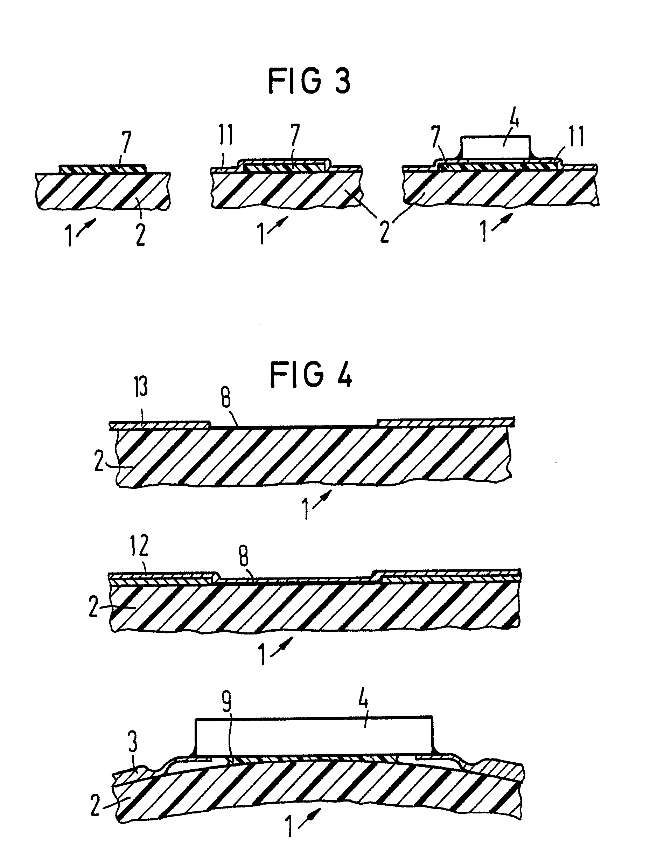

Um ein solches geringfügiges Verschieben der Leiterbahnanschlüsse zu ermöglichen, ist es aber nicht unbedingt erforderlich, die gesamte äusserste Kupferlage einer Leiterplatte mit Hilfe eines elastischen Klebermaterials auf den Träger aufzubringen. Ein ähnlicher Effekt lässt sich auch erreichen, wenn, wie in Figur 3 gezeigt, nur jeweils im Bereich der Einbauplätze für die Bausteine 4 eine elastische Schicht 7 angeordnet und darüber ganzflächig eine weitere Kupferschicht 11 aufgebracht ist, aus der dann die Leiterbahnen in an sich bekannter Weise freigeätzt sind.

Figur 4 zeigt schliesslich eine Möglichkeit für die Ausgestaltung der Dehnungsglieder oder Dehnungsschleifen bzw. für das Ermöglichen einer geringfügigen Verschiebung der Leiterbahnen 3 gegenüber dem Träger 2. Figur 4 zeigt im oberen Teil, dass im Bereich eines Einbauplatzes für einen Baustein 4 die äusserste Kupferlage 13 der Leiterplatte 1 weggeätzt und die freie Fläche mit einem Mittel 8 benetzt ist, das die Haftung zwischen dem Trägermaterial 2 und einer darauf aufzubringenden weiteren Kupferschicht 12 schwächt bzw. verhindert. Das Aufbringen einer solchen Kupferschicht 12 zeigt der mittlere Teil von Figur 4. Der untere Teil von Figur 4 zeigt schliesslich, wie ein Baustein 4 an die Anschlüsse der Leiterbahnen 3, die aus der Kupferschicht 12 in an sich bekannter Weise freigeätzt sind, angelötet ist und dass diese Leiterbahnanschlüsse im Bereich des Einbauplatzes für den Baustein 4 nicht mit dem Trägermaterial 2 der Leiterplatte 1 verbunden sind. Damit der Baustein 4 aber einen genügenden Halt auf der Leiterplatte 1 hat, ist es zweckmässig, den Baustein 4 mit Hilfe eines elastischen Klebers 9 auf dem Träger 2 der Leiterplatte 1 zu befestigen.

Ferner ist es möglich, einen Dehnungsausgleich in der Leiterplatte zu erreichen, indem bei einer fertig geätzten Leiterplatte im Bereich der Einbauplätze der Bausteine die Kunststoffmoleküle des Trägermaterials durch eine chemische Behandlung zerkleinert und damit weich sind. Dadurch ist es möglich, dass sich Baustein 4 einerseits und Leiterbahn 3 andererseits über dem weichen Trägermaterial 2 verschieben können und damit evtl. auftretende mechanische Spannungen auf ein für diese Teile ungefährliches Mass zu verringern.

## Patentansprüche

1. Leiterplatte (1) mit einer Einrichtung zum Verhindern von Beschädigungen von elektrischen/ elektronischen Bausteinen (4) und von Leiterbahnen (3) infolge mechanischer Spannungen zwischen den elektrischen/elektronischen Bausteinen (4) und den Leiterbahnen (3) bei Verformung der Leiterplatte (1), wobei die Einrichtung Dehnungsglieder (5) in den zum Anlöten der Bausteine (4) dienenden Leiterbahnanschlüssen aufweist, gekennzeichnet durch eine zumindest im Bereich von Einbauplätzen für die Bausteine (4) auf dem Träger (2) der Leiterplatte befindliche elastische Schicht (6, 7) mit darauf befindlichen Leiterbahnen (3), die aus einer Kupferschicht (10, 11) in an sich bekannter Weise freigeätzt sind.

2. Leiterplatte (1) nach Anspruch 1, dadurch gekennzeichnet, dass die gesamte Kupferschicht (10) der Leiterplatte (1) mit Hilfe eines elastischen Klebematerials (6) auf den Träger (2) der Leiterplatte (1) aufgebracht ist und aus dieser Kupferschicht die Leiterbahnen in an sich bekannter Weise freigeätzt sind.

3. Leiterplatte (1) nach Anspruch 1, dadurch gekennzeichnet, dass auf dem Träger (2) der Leiterplatte (1) nur im Bereich der Einbauplätze für die Bausteine (4) eine elestische Schicht (7) angeordnet ist und die Leiterbahnen (3) aus einer darüber ganzflächig aufgebrachten Kupferschicht (11) in an sich bekannter Weise freigeätzt sind.

4. Leiterplatte (1) nach Anspruch 1, dadurch gekennzeichnet, dass bei einer fertiggeätzten Leiterplatte (1) im Bereich der Einbauplätze der Bausteine (4) die Kunststoffmoleküle des Trägermaterials (2) durch chemische Behandlung zerkleinert sind und damit das Trägermaterial «weich» ist.

5. Leiterplatte (1) mit einer Einrichtung zum Verhindern von Beschädigungen von elektrischen/ elektronischen Bausteinen (4) und von Leiterbahnen (3) infolge mechanischer Spannungen zwischen den elektrischen/elektronischen Bausteinen (4) und den Leiterbahnen (3) bei Verformung der Leiterplatte (1), wobei die Einrichtung Dehnungsglieder (5) in den zum Anlöten der Bausteine (4) dienenden Leiterbahnanschlüssen aufweist, dadurch gekennzeichnet, dass die auf dem Träger (2) der Leiterplatte (1) befindliche Kupferlage (13) im Bereich der Einbauplätze weggeätzt ist und die freien Flächen mit einem Mittel (8) benetzt sind, das die Haftung zwischen dem Trägermaterial (2) und einer darauf aufgebrachten weiteren Kupferschicht (12) schwächt, aus der die Leiterbahnen (3) in an sich bekannter Weise freigeätzt sind.

6. Leiterplatte nach Anspruch 5, dadurch gekennzeichnet, dass die Bausteine (4) mit Hilfe eines elastischen Klebers (9) auf dem Träger (2) befestigt sind.

## Claims

1. A circuit board (1) with a device for preventing damage to electrical/electronic modules (4) and conductor paths (3) due to mechanical stresses between the electrical/electronic modules (4) and the conductor paths (3) when the circuit board (1) is deformed, where the device comprises expansion members (5) in the conductor path terminals to which the modules (4) are soldered, characterised by an elastic layer (6, 7) which is arranged, at least in the region of installation locations for the modules (4), on the carrier (2) of the circuit board and on which are arranged conductor paths (3) which are etched out of a copper layer (10, 11) in a manner known per se.

2. A circuit board (1) as claimed in Claim 1, characterised in that the entire copper layer (10) of the circuit board (1) is set up on the carrier (2) of the circuit board (1) by means of an elastic adhesive material (6); and that the conductor paths are etched out of this copper layer in a manner known per se.

3. A circuit board (1) as claimed in Claim 1, characterised in that an elastic layer (7) is arranged on the carrier (2) of the circuit board (1) only in the region of the installation locations for the modules (4); and that the conductor paths (3) are etched in a manner known per se out of a copper layer (11) applied over the elastic layer (7) to cover the entire surface.

4. A circuit board (1) as claimed in Claim 1, characterised in that when the etching of the circuit board (1) has been completed, in the region of the installation locations of the modules (4), the synthetic resin molecules of the carrier material (2) are reduced in size by chemical treatment and as a result, the carrier material is "soft".

5. A circuit board (1), comprising a device which prevents damage to electrical/electronic modules (4) and to conductor paths (3) due to mechanical stresses between the electrical/electronic modules (4) and the conductor paths (3) when the circuit board (1) is deformed, where the device comprises expansion members (5) in the conductor path terminals to which the modules (4) are soldered, characterised in that the copper layer (13) present on the carrier (2) of the circuit board (1) is etched away in the region of the installation locations, and the exposed surfaces are wetted with an agent (8) which weakens the bond between the carrier material (2) and a further copper layer (12) which is applied thereto and from which the conductor paths (3) are etched in a manner known per se.

6. A circuit board as claimed in Claim 5, characterised in that the modules (4) are secured to the carrier (2) by means of an elastic adhesive (9).

**Revendications**

1. Plaque de circuit imprimé (1) avec un dispositif pour empêcher la détérioration de modules électriques/électroniques (4) et de pistes conductrices (3) par suite de contraintes mécaniques entre les modules électriques/électroniques (4), ledit dispositif comportant des éléments de dilatation (5) dans les bornes des pistes conductrices qui servent au soudage de modules (4), caractérisée par une couche élastique (6, 7) se situant au moins dans la zone d'emplacements de montage pour les modules sur le support (2) de la plaque de circuit imprimé, et pourvue sur elle de pistes conductrices (3) qui ont été dégagées, de façon connue, par attaque d'une couche de cuivre (10, 11).

2. Plaque de circuit imprimé (1) selon la revendication 1, caractérisée par le fait que la totalité de la couche de cuivre (10) de la plaque de circuit imprimé (1) est déposée, à l'aide d'un matériau adhésif et élastique (6), sur le support (2) de la plaque de circuit imprimé (1), et que de façon connue en soi, les pistes conductrices sont dégagées de cette couche de cuivre par attaque.

3. Plaque de circuit imprimé (1) selon la revendication 1, caractérisée par le fait que sur le support (2) de la plaque de circuit imprimé (1), une couche élastique (7) est prévue dans la zone des emplacements de montage pour les modules (4) et les pistes conductrices (3) sont dégagées par attaque, et de façon connue en soi, dans une couche superposée et d'un seul tenant.

4. Plaque de circuit imprimé (1) selon la revendication, caractérisée par le fait que dans le cas d'une plaque de circuit imprimé déjà attaquée, les molécules de matière plastique du matériau du support (2) sont fragmentées, dans la zone des emplacements de montage des modules (4), par traitement thermique et que de ce fait le matériau du support est rendu «mou».

5. Plaque de circuit imprimé (1) avec un dispositif pour empêcher la détérioration de modules électriques/électroniques (4) et de pistes conductrices (3) par suite de contraintes mécaniques entre les modules électriques/électroniques (4), ledit dispositif comportant des éléments de dilatation (5) dans les bornes des pistes conductrices qui servent au soudage de modules (4), caractérisée par le fait que la couche de cuivre (13) qui se trouve sur le support (2) de la plaque de circuit imprimé (1), est enlevée par attaque dans la zone des emplacements de montage, et que les surfaces libres sont mouillées avec un moyen (8) qui affaiblit l'adhérence entre le matériau constitutif du support (2) et une seconde couche de cuivre (qui y est déposée) et dans laquelle sont dégagées, de façon connue, par attaque, les pistes conductrices (3).

6. Plaque de circuit imprimé selon la revendication 5, caractérisée par le fait que les modules (4) sont fixés sur le support (2) à l'aide d'un adhésif élastique (9).

## FIG 2

## FIG 1

# FIG 3

# FIG 4